# EUROPEAN PATENT SPECIFICATION

(11) **EP 3 432 407 B1**
(45) Date of publication and mention of the grant of the patent: **28.02.2024**
(21) Application number: 16894351.2
(22) Date of filing: 15.03.2016
(51) Int. Cl.: H01M 10/42, H01M 10/48

(54) **STORAGE BATTERY DEVICE, STORAGE BATTERY DEVICE CONTROL METHOD, AND PROGRAM**
SPEICHERBATTERIEVORRICHTUNG, SPEICHERBATTERIEVORRICHTUNGSTEUERUNGSVERFAHREN UND PROGRAMM
DISPOSITIF D'ACCUMULATEUR, PROCÉDÉ DE COMMANDE DE DISPOSITIF D'ACCUMULATEUR ET PROGRAMME

(43) Date of publication of application: 23.01.2019
(73) Proprietor: Kabushiki Kaisha Toshiba, Tokyo 105-0023 (JP); Toshiba Infrastructure Systems & Solutions Corporation, Kawasaki-shi, Kanagawa 212-0013 (JP)
(72) Inventor: ONODA, Takayuki, Tokyo 105-8001 (JP); OKABE, Ryo, Tokyo 105-8001 (JP); KANEKO, Norihiro, Tokyo 105-8001 (JP); KIKUCHI, Yusuke, Tokyo 105-8001 (JP); KURODA, Kazuto, Tokyo 105-8001 (JP); SEKINO, Masahiro, Tokyo 105-8001 (JP); TAKAHASHI, Jun, Tokyo 105-8001 (JP)
(74) Representative: AWA Sweden AB
(86) International application number: PCT/JP2016/058171
(87) International publication number: WO 2017/158729

(56) References cited:
- EP-A1- 2 293 375
- EP-A1- 2 765 643
- EP-A2- 2 720 348
- JP-A- 2012 050 272
- JP-A- 2013 031 324
- JP-A- 2013 070 441
- JP-A- 2013 077 520
- JP-A- 2013 077 520

## Description

### FIELD

An embodiment relates to a storage battery device, a storage battery device control method, and a computer-readable medium.

### BACKGROUND

Conventionally known is a device that is provided with a battery system including a plurality of battery modules and a monitoring device that monitors the battery modules, and a battery management unit that is connected to the battery system. The battery management unit receives information related to voltages, temperatures, and the like of the battery modules included in the battery system from the monitoring device, and transmits the information, together with identification information of the monitoring device, to an upper-level device. Previous patent document JP 2013 070441 A discloses a battery system that implements improved starting and operating safety and a method of operating a storage battery device. Further, previous patent document EP 2 293 375 A1 discloses a battery identification setting system and method of setting battery identification parameters.

However, as the power capacity of the storage battery device is increased, the number of battery modules managed by one battery management unit is also increased. Such an increase has made it difficult to identify the battery modules and the monitoring devices, disadvantageously.

An embodiment is made in consideration of the above, and an object of the embodiment is to provide a storage battery device, a storage battery device control method, and a program capable of improving the accuracy at which the battery modules and the monitoring devices increasing in number are identified.

### BRIEF DESCRIPTION OF DRAWINGS

FIG. 1 is a schematic of an overall configuration of a storage battery system according to an embodiment.
FIG. 2 is a flowchart of an individual identification information generating process performed by an operating unit.
FIG. 3 is one example of an individual identification information table including the individual identification information generated by the operating unit.
FIG. 4 is a flowchart of a communication frame transmitting/receiving process performed by the operating unit.
FIG. 5 is one example of a second communication frame transmitted from a cell monitoring unit to the operating unit.
FIG. 6 is one example of a first communication frame transmitted from the operating unit to a gateway device.
FIG. 7 is a schematic illustrating a data structure of a data part included in the first communication frame.
FIG. 8 is a schematic illustrating a data structure of a data part of a first communication frame according to a modification.

### DETAILED DESCRIPTION

According to an embodiment, a storage battery device includes a first battery system, a second battery system, and a battery management unit. The first battery system includes a plurality of first battery modules, and a plurality of first monitoring units detecting module information that is information related to the first battery modules, and each having first monitoring identification information. The second battery system includes a plurality of second battery modules, and a plurality of second monitoring units detecting module information that is information related to the second battery modules, and each having second monitoring identification information. The battery management unit receives a first lower-level communication frame containing the first monitoring identification information and the module information from the first monitoring units. The battery management unit receives a second lower-level communication frame containing the second monitoring identification information and the module information from the second monitoring units. The battery management unit transmits, to an upper-level device of the battery management unit, an upper-level communication frame that contains individual identification information assigned to each of the first monitoring units and the second monitoring units based on system identification information assigned to each of the first battery system and the second battery system, the first monitoring identification information, and the second monitoring identification information, and that also contains the module information detected by the first monitoring unit or the second monitoring unit corresponding to the individual identification information, and that has a larger data size than the first lower-level communication frame and the second lower-level communication frame.

Some exemplary embodiments and modifications described below include the same elements. Therefore, in the explanation hereunder, the same reference numerals are assigned to the same elements, and redundant explanations thereof will be partly omitted. A part that is included in one embodiment or modification may be replaced with a corresponding part included in another embodiment or modification. Furthermore, unless specified otherwise, a configuration, a position, and the like of a part included in one embodiment or modification are the same as those in the other embodiment or modification.

### <Embodiment>

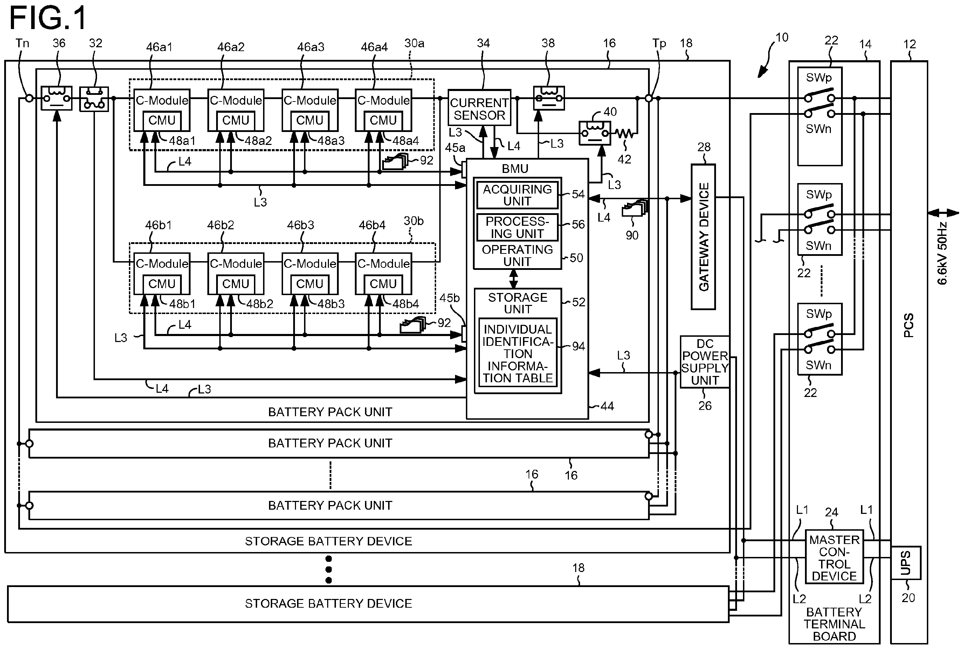

FIG. 1 is a schematic of an overall configuration of a storage battery system 10 according to the embodiment. The storage battery system 10 is connected to a power system, such as an external commercial power supply, via a transformer, for example, and discharges power to the power system, and is charged with the power supplied from the power system. As illustrated in FIG. 1, the storage battery system 10 includes a power conditioning system (PCS) 12, a battery terminal board 14, and one or more (e.g., sixteen) storage battery devices 18 that include battery pack units 16.

The PCS 12 is connected to an external power system. The PCS 12 converts the DC power supplied from the storage battery devices 18 to AC power at a frequency and a voltage suitable for the power system, and discharges the AC power to the power system. The PCS 12 converts the AC power supplied from the power system into DC power at a voltage that is chargeable by the storage battery devices 18, and supplies the DC power to the storage battery devices 18. One example of the AC power supplied from the power system is one having a voltage of 6.6 kilovolts and a frequency of 50 hertz. The PCS 12 is connected to a control communication line L1 that is in accordance with a first communication protocol. One example of the first communication protocol is Keyword-Protocol (KWP) 2000 on Ethernet (registered trademark) that is an extension of ISO15765. The PCS 12 has an uninterruptible power system (UPS) 20. The UPS 20 is connected to a control power supply line L2. The UPS 20 keeps supplying power to the storage battery devices 18 for a certain length of time even when the power supply from the external power system stops.

The battery terminal board 14 includes one or more switch circuits 22 and a master control device 24.

The number of switch circuits 22 is the same as the number of the storage battery devices 18. The switch circuits 22 are provided correspondingly to the respective storage battery devices 18. Each of the switch circuit 22 has a positive-electrode side switching member SWp and a negative-electrode side switching member SWn. The switching members SWp, SWn are opened and closed manually, for example. The positive-electrode side switching member SWp establishes or breaks a circuit between the positive-electrode side terminal Tp of each one of the battery pack units 16 that are included in one of the storage battery devices 18, and the PCS 12. The negative-electrode side switching member SWn establishes or breaks a circuit between the negative-electrode side terminal Tn of each one of the battery pack units 16 that are included in one of the storage battery devices 18, and the PCS 12. The positive-electrode side terminal Tp and the negative-electrode side terminal Tn of the battery pack unit 16 will be described later. The voltage between one switching member SWp and the other switching member SWn is set to a range from 490 volts to 778 volts or so, for example.

The master control device 24 is a computer including a transmitter/receiver for communicating with the external, a micro-processor executing a program, and a storage device, for example. The master control device 24 monitors and controls the conditions of the battery pack units 16. The master control device 24 is connected to the control communication line L1 that is connected to the PCS 12, and to the control power supply line L2 that is connected to the UPS 20. The master control device 24 transmits and receives control information to and from the PCS 12 via the control communication line L1 over the first communication protocol. The master control device 24 supplies, in case of a power failure, the power supplied from the UPS 20 to the storage battery devices 18 via the control power supply line L2.

The storage battery device 18 includes a DC power supply unit 26, a gateway device 28, and one or more battery pack units 16.

The DC power supply unit 26 is connected to the master control device 24 and the UPS 20 via the control power supply line L2. The DC power supply unit 26 is supplied with 100-volt AC power, for example, that is supplied from the UPS 20 to the master control device 24, in case of a power failure, via the control power supply line L2. The DC power supply unit 26 then supplies 12-volt DC power, for example, to the battery pack unit 16.

The gateway device 28 is bidirectionally communicatively connected to the master control device 24 via the control communication line L1. The gateway device 28 communicates with the master control device 24 over the first communication protocol. The gateway device 28 transmits and receives control information to and from the master control device 24, for example. The gateway device 28 is bidirectionally communicatively connected to the battery pack units 16 over the first communication protocol. The gateway device 28 is one example of an upper-level device for battery systems 30a, 30b and of a battery management units 44 included in the battery pack units 16, as will be described later. For example, the gateway device 28 controls the battery systems 30a, 30b and the battery management units 44, based on module information MD related to voltages, temperatures, and the like, and information related to the currents received from the battery pack units 16, and the control information, for example.

The battery pack unit 16 includes a plurality of (e.g., two) battery systems 30a, 30b, a service disconnector 32, a current sensor 34, a negative-electrode side circuit breaker 36, a positive-electrode side circuit breaker 38, a pre-charge circuit breaker 40, a pre-charge resistor 42, and a battery management unit (BMU) 44.

The battery system 30a includes a plurality of (e.g., four) battery modules 46an, and a plurality of cell monitoring units (CMUs) 48an. n is a positive integer, and in this embodiment, n = 1, 2, 3, 4.

The battery modules 46an are also referred to as cell modules. The battery modules 46an are connected serially. Each of the battery modules 46an has 24 rechargeable secondary batteries, such as lithium-ion batteries (20 ampere hour-2.4 volts). Two out of the 24 lithium-ion batteries are connected in parallel, and 12 pairs, each pair of which including two lithium-ion batteries connected in parallel, are serially connected. In FIG. 1, the left side of the battery system 30a represents the negative-electrode side, and the right side of the battery system 30a represents the positive-electrode side.

The number of the CMUs 48an is the same as the number of the battery modules 46an. The CMUs 48an are provided correspondingly to the respective battery modules 46an. The CMU 48an is a computer that includes transmitting/receiving unit communicating with the BMU 44, a micro-processor that executes a program, and a storage unit storing therein a program and information such as module information. The CMU 48an monitors the battery module 46an by detecting the module information MD including information of the voltage and the temperature of the battery module 46an, the voltage and the temperature information being one example of information related to the battery module 46an. Each of the CMUs 48an has first monitoring identification information ID_M1n (n = 1, 2, ...) that is information for identifying the CMU 48an, and that is stored in the storage unit. The CMU 48an transmits the module information MD, together with its first monitoring identification information ID_M1n, to the BMU 44.

The battery system 30b is connected in parallel with the battery system 30a. The battery system 30b includes a plurality of (e.g., four) battery modules 46bn and a plurality of CMUs 48bn. The battery system 30b has the same configuration as that of the battery system 30a.

Each of the CMUs 48bn has second monitoring identification information ID_M2n. The CMU 48bn monitors the battery module 46bn by detecting module information MD including the information of the voltage and the temperature of the battery module 46bn, the voltage and the temperature information being one example of information related to the battery module 46bn. Each of the CMUs 48bn has second monitoring identification information ID_M2n that is information for identifying the CMU 48bn. Each of the CMUs 48bn transmits the module information MD, together with its second monitoring identification information ID_M2n, to the BMU 44.

The CMU 48an, 48bn is in one-to-one relation with the battery module 46an, 46bn. Therefore, the monitoring identification information ID_M1n, ID_M2n of the CMU 48an, 48bn is identification information also capable of identifying the battery module 46an, 46bn. At least a part of the second monitoring identification information ID_M2n may be redundant with, that is, have the same values as, at least a part of the first monitoring identification information ID_M1n. In this embodiment, it is assumed that the same identification information is assigned to the first monitoring identification information ID_M1n and the second monitoring identification information ID_M2n having the same value in n.

In the explanation below, when it is not necessary to distinguish the battery systems 30a, 30b, the battery modules 46an, 46bn, and the CMUs 48an, 48bn from each other, these components will be referred to as a battery systems 30, a battery modules 46, and a CMUs 48, respectively. Furthermore, when it is not necessary to distinguish to which CMU 48 the first monitoring identification information ID_M1n and the second monitoring identification information ID_M2n belong, these pieces of monitoring information will be referred to as monitoring identification information ID_M.

The service disconnector 32 is serially connected to the negative-electrode side of the battery system 30. The service disconnector 32 includes a switch and a fuse. When any of the battery modules 46 are removed or attached due to a maintenance, for example, the service disconnector 32 enables a user to manually break the connection between the battery system 30 and the external. If any one of the battery terminal board 14 and the PCS 12 includes a fuse, the fuse in the service disconnector 32 may be omitted. The service disconnector 32 is provided with a wiring for notifying the insertion/removal condition and the fuse condition to the BMU 44, which will be described later.

The current sensor 34 is serially connected to the positive-electrode side of the battery system 30. The current sensor 34 transmits a detection of a current to the BMU 44.

Each of the negative-electrode side circuit breaker 36, the positive-electrode side circuit breaker 38, and the pre-charge circuit breaker 40 includes a coil, for example, and is a contactor that is switched between an established state and a broken state, by being supplied with power. The negative-electrode side circuit breaker 36, the positive-electrode side circuit breaker 38, and the pre-charge circuit breaker 40 may also be relays or breakers (e.g., fuse-free breakers).

The negative-electrode side circuit breaker 36 is connected between the service disconnector 32 and the negative-electrode side terminal Tn of the battery pack unit 16. The negative-electrode side circuit breaker 36 is connected to the negative-electrode side of the battery system 30 via the service disconnector 32. The negative-electrode side circuit breaker 36 is connected to the negative-electrode side switching member SWn, via the negative-electrode side terminal Tn. The negative-electrode side circuit breaker 36 switches to establish (or close) and to break (or open) a circuit between the negative-electrode side of the battery system 30 and the negative-electrode side switching member SWn.

The positive-electrode side circuit breaker 38 is connected between the current sensor 34 and the positive-electrode side terminal Tp of the battery pack unit 16. The positive-electrode side circuit breaker 38 is connected to the positive-electrode side of the battery system 30 via the current sensor 34. The positive-electrode side circuit breaker 38 is connected to the positive-electrode side switching member SWp, via the positive-electrode side terminal Tp. The positive-electrode side circuit breaker 38 switches to establish (or close) and to break (or open) a circuit between the positive-electrode side of the battery system 30 and the positive-electrode side switching member SWp.

The pre-charge circuit breaker 40 is connected between the current sensor 34 and the positive-electrode side terminal Tp of the battery pack unit 16 via the pre-charge resistor 42. The pre-charge circuit breaker 40 is connected in parallel with the positive-electrode side circuit breaker 38, on the positive-electrode side of the battery pack unit 16. The pre-charge circuit breaker 40 is connected to the positive-electrode side of the battery system 30 via the current sensor 34. The pre-charge circuit breaker 40 is connected to the positive-electrode side switching member SWp via the pre-charge resistor 42 and the positive-electrode side terminal Tp. The pre-charge circuit breaker 40 switches to establish (or close) and to break (or open) a circuit between the positive-electrode side of the battery system 30 and the positive-electrode side switching member SWp.

The pre-charge resistor 42 is connected between the pre-charge circuit breaker 40 and the positive-electrode side terminal Tp of the battery pack unit 16. In other words, the pre-charge resistor 42 is connected serially to the pre-charge circuit breaker 40. To charge elements such as a capacitor in an inverter included in the PCS 12, the pre-charge resistor 42 reduces the current that flows at the time of start-up so that a surge current at the time of start-up is suppressed.

The BMU 44 is connected to the DC power supply unit 26 via the power supply line L3, in a manner enabled to receive the DC power. The BMU 44 is connected to the CMUs 48an included in the battery system 30a, the CMUs 48bn included in the battery system 30b, the current sensor 34, the negative-electrode side circuit breaker 36, the positive-electrode side circuit breaker 38, and the pre-charge circuit breaker 40 via the power supply line L3, in a manner enabled to supply the DC power received from the DC power supply unit 26. For example, the BMU 44 controls to establish and to break the circuit in the circuit breakers 36, 38, and 40 by supplying the power to the negative-electrode side circuit breaker 36, the positive-electrode side circuit breaker 38, and the pre-charge circuit breaker 40.

The BMU 44 is connected with the gateway device 28 via the communication line L4, in a manner enabled to transmit and to receive information. The BMU 44 communicates with the gateway device 28 using a first communication frame 90 in accordance with the first communication protocol. The first communication frame 90 is one example of an upper-level communication frame. The BMU 44 is connected with the CMUs 48an included in the battery system 30a, the CMUs 48bn included in the battery system 30b, the service disconnector 32, and the current sensor 34, via the communication line L4, in a manner enabled to transmit and to receive information. The BMU 44 communicates with the CMUs 48, the service disconnector 32, and the current sensor 34 using a second communication frame 92 based on a second communication protocol that is different from the first communication protocol. One example of the second communication protocol is KWP2000 on Controller Area Network (CAN) protocol specified in ISO15765/14230. The data size of the first communication frame 90 is larger than that of the second communication frame 92. For example, the BMU 44 receives the first monitoring identification information ID_M1n, the second monitoring identification information ID_M2n, and the module information MD from the CMUs 48an in the battery system 30a and from the CMUs 48bn included in the battery system 30b.

The BMU 44 includes connectors 45a, 45b. A communication line L4 for transmitting and receiving the module information MD to and from the CMUs 48an in the battery system 30a, and a communication line L4 for transmitting and receiving the module information MD to and from the CMUs 48bn in the battery system 30b are connected separately to the connectors 45a, 45b. Each of the connectors 45a, 45b has a system identification information ID_Sm (m = 1, 2). For example, the connector 45a has system identification information ID_S1. The connector 45b has system identification information ID_S2 that is different from the system identification information ID_S1. One connector 45 is connected to one battery system 30. Therefore, the system identification information ID_S1, ID_S2 that are assigned to the connectors 45a, 45b also serve as information that identify the battery systems 30a, 30b, and are assigned to the battery systems 30a, 30b. The BMU 44 identifies the battery systems 30a, 30b using the gateway function, based on the system identification information ID_S1, ID_S2 given to the connectors 45a, 45b to which the battery systems 30a, 30b are connected. In the explanation below, when it is not necessary to distinguish the connectors 45a, 45b, these connectors will be referred to as connectors 45. When it is not necessary to distinguish the system identification information ID_S1, ID_S2, these pieces of information will be referred to as system identification information ID_S.

The BMU 44 is, for example, a computer that also includes an operating unit 50 that is a micro-processor executing a program, and a storage unit 52 storing therein a program, control information, and the like.

The operating unit 50 communicates with an upper-level device such as the gateway device 28 via a communication interface, for example. The operating unit 50 communicates with the CMUs 48 via the communication line L4 and the connectors 45. The storage unit 52 includes, for example, a random access memory (RAM), a read-only memory (ROM), a hard disk drive (HDD), and a solid state drive (SSD). The operating unit 50 functions as an acquiring unit 54 and a processing unit 56 by reading a program and information such as parameters stored in the storage unit 52. The operating unit 50 reads a program corresponding to a process of generating individual identification information ID_P, and a program corresponding to a process of transmitting and receiving the communication frames 90, 92, for example. The acquiring unit 54 and the processing unit 56 may be, partly or entirely, implemented as hardware in a circuit such as an application specific integrated circuit (ASIC).

The acquiring unit 54 acquires control information from the gateway device 28. The acquiring unit 54 supplies the DC power to the current sensor 34, and acquires current information measured by the current sensor 34. The acquiring unit 54 acquires information such as information of the insertion/removal condition and the fuse condition of the service disconnector 32 from the service disconnector 32.

The acquiring unit 54 acquires the module information MD including the voltage information and the temperature information of the battery modules 46 from the CMUs 48, together with the monitoring identification information ID_M. The acquiring unit 54 acquires the second communication frame 92 including the module information MD and the monitoring identification information ID_M from a first CMU 48a. The second communication frame 92 is one example of a first lower-level communication frame. The acquiring unit 54 acquires the second communication frame 92 including the module information MD and the monitoring identification information ID_M from a second CMU 48b. The second communication frame 92 is one example of a second lower-level communication frame. The acquiring unit 54 may also acquire only the monitoring identification information ID_M from the first CMU 48a and the second CMU 48b, separately from the module information MD. The acquiring unit 54 also acquires the system identification information ID_S of the connector 45 via which the module information MD and the monitoring identification information ID_M are acquired.

The processing unit 56 controls the battery pack units 16 based on the information acquired by the acquiring unit 54.

Specifically, the processing unit 56 supplies or stops the supply of the DC power based on the control information or the like received from the gateway device 28 by the acquiring unit 54, and controls the closed state and the open state of the negative-electrode side circuit breaker 36, the positive-electrode side circuit breaker 38, and the pre-charge circuit breaker 40.

If the processing unit 56 determines that the battery system 30 or the like has failed based on the voltage information, the temperature information, and the current information received from the CMU 48 and the current sensor 34, the processing unit 56 switches the negative-electrode side circuit breaker 36, the positive-electrode side circuit breaker 38, and the pre-charge circuit breaker 40 to the open state. As a result, the processing unit 56 establishes or breaks a circuit with the battery system 30.

Based on the monitoring identification information ID_M and the system identification information ID_S of the connector 45 via which the monitoring identification information ID_M is received, the processing unit 56 generates and assigns different (that is, not redundant) individual identification information ID_P, for each of the CMUs 48. The processing unit 56 then stores an individual identification information table 94 in which the individual identification information ID_P is mapped to the first monitoring identification information ID_M1n or the second monitoring identification information ID_M2n, and to the system identification information ID_S, in the storage unit 52. The processing unit 56 manages the individual identification information ID_P using the individual identification information table 94. If a second communication frame 92 including monitoring identification information ID_M and module information MD is received from the acquiring unit 54, the processing unit 56 converts the second communication frame 92 into a first communication frame 90 including the individual identification information ID_P and the module information MD detected by the first CMU 48a or the second CMU 48b corresponding to the individual identification information ID_P, based on the communication format of the first communication protocol, and transmits the first communication frame 90 to the gateway device 28.

The processing unit 56 transmits the module information MD mapped with the generated individual identification information ID_P to the gateway device 28. At this time, because the first monitoring identification information ID_M1n and the second monitoring identification information ID_M2n are redundant, the same monitoring identification information ID_M is mapped to the pieces of module information MD acquired from different battery modules 46. However, because the processing unit 56 assigns individual identification information ID_P that is unique to each of the battery modules 46 to the module information MD, and that is mapped to the monitoring identification information ID_M and the system identification information ID_S, it is possible to identify to which battery module 46 these pieces of the module information MD are related.

An operation of the storage battery system 10 will now be explained. In the storage battery system 10, the BMU 44 controls the circuit breakers 36, 38, and 40 to establish or to break a circuit between the battery system 30 and the external, based on the control information received from the gateway device 28. When the circuit is established by the switch circuit 22 while the circuits are established by the circuit breakers 36, 38, and 40, the battery system 30 becomes connected to the PCS 12. The PCS 12 converts the power received from the battery systems 30, and supplies the resultant power to the external. In the storage battery system 10, the PCS 12 also converts the power received from the external as the power for charging the battery systems 30 that become connected via the circuit breakers 36, 38, and 40 and the switch circuit 22 that are in the established state, and supplies the power to the battery system 30.

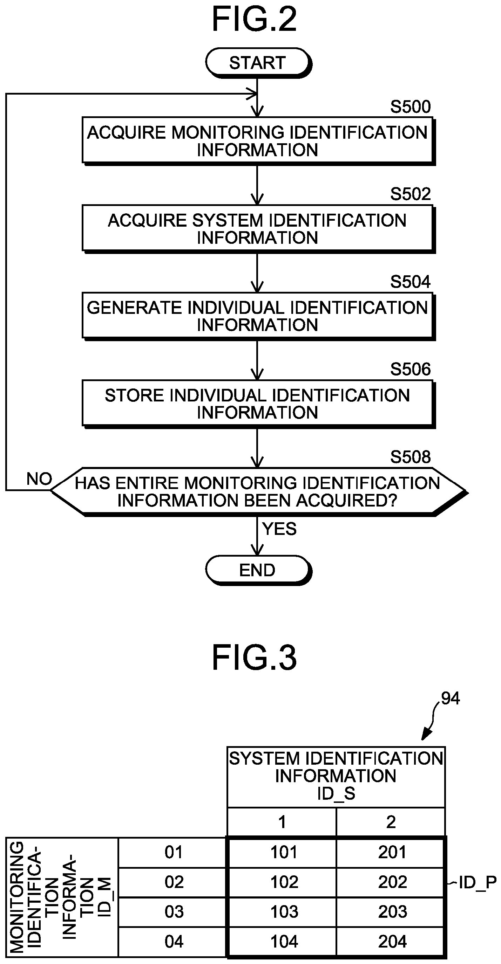

FIG. 2 is a flowchart of a process of generating the individual identification information ID_P, performed by the operating unit 50. The operating unit 50 starts the process illustrated in this flowchart by reading a program of the process of generating the individual identification information ID_P, stored in the storage unit 52. The process of generating the individual identification information ID_P is one example of a method for controlling the storage battery devices 18.

As illustrated in FIG. 2, the acquiring unit 54 acquires the monitoring identification information ID_M from the CMU 48, and outputs the information to the processing unit 56 (S500). At Step S500, the acquiring unit 54 may acquire the monitoring identification information ID_M by receiving the second communication frame 92 including the monitoring identification information ID_M and the module information MD from the CMU 48, instead of receiving the monitoring identification information ID_M only. The acquiring unit 54 acquires the system identification information ID_S from the connector 45 via which the monitoring identification information ID_M is received, and outputs the system identification information ID_S to the processing unit 56 (S502).

The processing unit 56 then generates individual identification information ID_P that is different from each other without any redundancy, based on the monitoring identification information ID_M and system identification information ID_S, in accordance with a predetermined rule (S504). The processing unit 56 then stores the individual identification information ID_P in the storage unit 52, in a manner mapped to the monitoring identification information ID_M and the system identification information ID_S (S506). The process at Step S500 and thereafter is repeated until the acquiring unit 54 acquires the entire monitoring identification information ID_M (No at S508). If the acquiring unit 54 acquires the entire monitoring identification information ID_M (Yes at S508), the operating unit 50 ends the process of generating the individual identification information ID_P.

FIG. 3 is one example of the individual identification information table 94 including the individual identification information ID_P generated by the operating unit 50. As illustrated in FIG. 3, the processing unit 56 in the operating unit 50 stores the individual identification information table 94 in which a piece of individual identification information ID_P is mapped with the monitoring identification information ID_M of the CMU 48 and the system identification information ID_S of the connector 45, in the storage unit 52. For example, the processing unit 56 generates individual identification information ID_P using a value of the system identification information ID_S as an M^{th} digit, and values of the monitoring identification information ID_M as the M-1^{th} and subsequent digits. In the example illustrated in FIG. 3, the processing unit 56 assigns the numbers from "101" to "104" to the CMUs 48a (and the battery modules 46a) that are included in the battery system 30a, as the individual identification information ID_P. In the example illustrated in FIG. 3, the processing unit 56 also assigns the numbers from "201" to "204" to the CMUs 48b (and battery modules 46b) that are included in the battery system 30b, as the individual identification information ID_P. The processing unit 56 may also acquire the system identification information ID_S and the monitoring identification information ID_M, and generate a value resultant of giving a serial number to these pieces of information, as the individual identification information ID_P. As a result, the processing unit 56 can extract the individual identification information ID_P enabled to identify one battery module 46 and one CMU 48 from the individual identification information table 94, based on the system identification information ID_S and the monitoring identification information ID_M having redundancy.

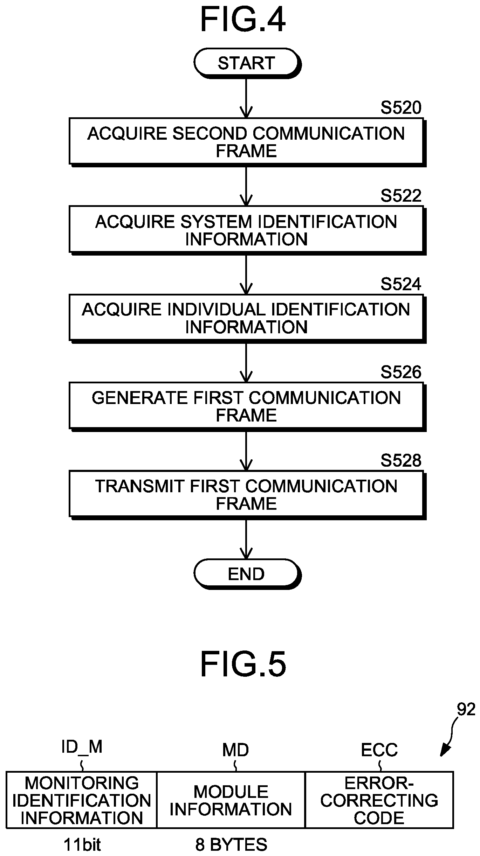

FIG. 4 is a flowchart of a process of transmitting and receiving the communication frames 90, 92, performed by the operating unit 50. The operating unit 50 starts the process illustrated in the flowchart by reading a program of the process of transmitting and receiving the communication frames 90, 92, the program being stored in the storage unit 52. The processing unit 56 may also read and execute the process of transmitting and receiving the communication frames 90, 92 upon receipt of a transmission request from the gateway device 28. The operating unit 50 may also read and execute the process of transmitting and receiving the communication frames 90, 92 in a manner continuous to the process of generating the individual identification information ID_P.

As illustrated in FIG. 4, the acquiring unit 54 acquires the second communication frame 92 including the monitoring identification information ID_M of the CMUs 48 and the module information MD of the battery modules 46 from some or all of the CMUs 48 included in any one of the battery systems 30, and outputs the second communication frame 92 to the processing unit 56 (S520). FIG. 5 is one example of the second communication frame 92 transmitted from the CMU 48 to the operating unit 50. For example, as illustrated in FIG. 5, the second communication frame 92 has a frame structure in accordance with the CAN communication protocol, and has a structure in which 11-bit monitoring identification information ID_M, 8-byte module information MD, and an error-correcting code (ECC) for correcting errors are arranged sequentially.

Referring back to FIG. 4, the acquiring unit 54 acquires the system identification information ID_S from the connector 45 via which the second communication frame 92 is acquired, and outputs the system identification information ID_S to the processing unit 56 (S522). The processing unit 56 acquires the individual identification information ID_P corresponding to the acquired monitoring identification information ID_M and system identification information ID_S, by extracting the individual identification information ID_P from the individual identification information table 94 (S524).

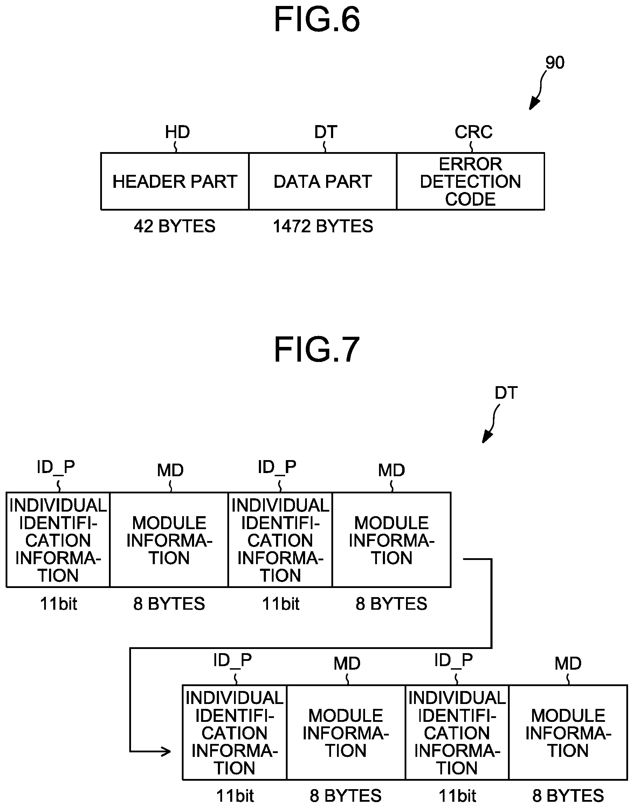

The processing unit 56 then generates a first communication frame 90 including the individual identification information ID_P and the module information MD (S526). FIG. 6 is one example of the first communication frame 90 transmitted from the operating unit 50 to the gateway device 28. For example, as illustrated in FIG. 6, the processing unit 56 generates a first communication frame 90 in which a 42-byte header part HD, a data part DT having 1472 bytes at the most, and a cyclic redundancy check (CRC) code for detecting errors are sequentially arranged, in accordance with the first communication protocol.

In the generation of the first communication frame 90, the processing unit 56 generates a header part HD containing a destination media access control (MAC) address (that is, the MAC address of the gateway device 28), a source MAC address (that is, the MAC address of the BMU 44), a destination internet protocol (IP) address, a source IP address, and a type indicating the frame type, for example.

FIG. 7 is a schematic illustrating a data structure of the data part DT included in the first communication frame 90. As illustrated in FIG. 7, in the generation of the first communication frame 90, the processing unit 56 generates a data part DT having a structure in which a plurality of pairs of the individual identification information ID_P and the module information MD are arranged. In other words, the processing unit 56 generates a data part DT including a plurality of pieces of individual identification information ID_P and a plurality of pieces of module information MD that are mapped to the respective pieces of individual identification information ID_P. For example, the processing unit 56 generates a data part DT including the individual identification information ID_P and the module information MD of all of the CMUs 48 and the battery modules 46 included in one battery system 30.

Referring back to FIG. 4, the processing unit 56 transmits the generated first communication frame 90 to the gateway device 28 (S528).

As described above, in the storage battery devices 18, the BMU 44 assigns different pieces of individual identification information ID_P to the respective CMUs 48 (and the battery modules 46) based on the monitoring identification information ID_M and the system identification information ID_S. As a result, the storage battery devices 18 can improve the accuracy at which the CMUs 48 and the battery modules 46 are identified, even when the numbers of the CMUs 48 and the battery modules 46 are increased.

In the storage battery devices 18, the BMU 44 generates individual identification information ID_P capable of identifying the CMU 48 and the battery module 46 even when the numbers of the CMUs 48 and the battery modules 46 are increased. With such identification information, because the BMU 44 transmits the individual identification information ID_P and the module information MD to an upper-level device such as the gateway device 28, in a manner mapped to each other, the upper-level device can identify to which battery module 46 the module information MD belongs highly accurately. As a result, the upper-level device can identify to which battery module 46 the module information MD belongs, even when the BMU 44 transmits the module information MD corresponding to a plurality of battery modules 46 all at once. Therefore, the BMU 44 can transmit an increased number of pieces of module information MD at once, and can transmit the entire module information MD included in one battery system 30 to the upper-level device all at once, for example.

### <Modification>

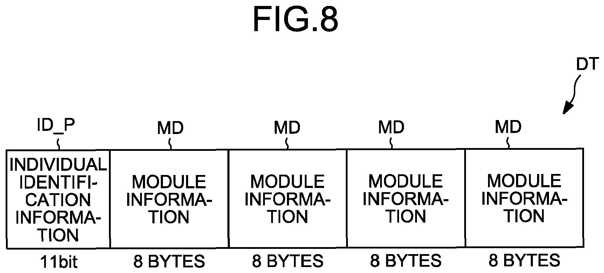

FIG. 8 is a schematic illustrating a data structure of a data part DT of the first communication frame 90 according to a modification. As illustrated in FIG. 8, the processing unit 56 may generate a data part DT in which one piece of individual identification information ID_P and a plurality of pieces of module information MD are arranged, in a manner following the individual identification information ID_P. The processing unit 56 uses the individual identification information ID_P corresponding to one of the pieces of module information MD included in the data part DT, as the individual identification information ID_P. For example, the processing unit 56 may use the individual identification information ID_P corresponding to the module information MD that is positioned at the head, as the individual identification information ID_P.

The processing unit 56 then arranges a plurality of pieces of module information MD following a predetermined rule. Specifically, the processing unit 56 generates a data part DT by concatenating the pieces of module information MD acquired from the CMUs 48 corresponding to the pieces of individual identification information ID_P that follow the individual identification information ID_P included in the data part DT, following a predetermined rule. For example, the processing unit 56 places the individual identification information ID_P (= 101) that has "01" as the monitoring identification information ID_M and "1" as the system identification information ID_S, as illustrated in FIG. 3, and the module information MD corresponding to this individual identification information ID_P at the head of the data part DT. The processing unit 56 then places, after the module information MD, the pieces of module information MD corresponding to the pieces of individual identification information ID_P that follow the individual identification information ID_P (that is, the module information MD corresponding to "102" to "104"). As a result, the gateway device 28 can identify, upon receipt of the first communication frame 90, to which battery module 46 each piece of module information MD belongs, using the one piece of individual identification information ID_P. Furthermore, the processing unit 56 can reduce the data size of the first communication frame 90, by using one piece of individual identification information ID_P.

The arrangement, the relations of connections, and the numbers, the information, and the functions of the elements may be changed as appropriate. The order of the steps included in the process described above may also be changed as appropriate.

For example, in the embodiment described above, the module information MD includes the voltage information and the temperature information of a battery module 46, but the module information MD may also include other information related to the battery module 46.

In the example explained in the embodiment above, the processing unit 56 converts the second communication frame 92 received from the CMU 48 into the first communication frame 90, and transmits the first communication frame 90 to the gateway device 28, but it is also possible to convert the first communication frame 90 into the second communication frame 92, and to transmit and to receive the second communication frame 92. For example, the processing unit 56 may convert the first communication frame 90 including the control information received from the gateway device 28, for example, into a second communication frame 92, and transmit the second communication frame 92 to the CMU 48.

## Claims

1. A storage battery device (18) comprising:
a first battery system (30a) including a plurality of first battery modules (46a), and a plurality of first monitoring units (48a) detecting module information that is information related to the first battery modules (46a), and each having first monitoring identification information;
a second battery system (30b) including a plurality of second battery modules (46b), and a plurality of second monitoring units (48b) detecting module information that is information related to the second battery modules (46b), and each having second monitoring identification information; and
a battery management unit (44), wherein
the battery management unit (44) is configured to:
receive a first lower-level communication frame containing the first monitoring identification information and the module information from the first monitoring units (48a),
receive a second lower-level communication frame containing the second monitoring identification information and the module information from the second monitoring units (46b), and
transmit, to an upper-level device (28), an upper-level communication frame that contains individual identification information assigned to each of the first monitoring units (48a) and the second monitoring units (48b) based on system identification information assigned to each of the first battery system (30a) and the second battery system (30b), the first monitoring identification information, and the second monitoring identification information, and that also contains the module information detected by the first monitoring unit (48a) or the second monitoring unit (48b) corresponding to the individual identification information, and that has a larger data size than the first lower-level communication frame and the second lower-level communication frame;
the first monitoring identification information is a sequence of pieces of information, each assigned to a respective first monitoring unit (48a1, 48a2, 48a3, 48a4) included in the first monitoring units (48a), the pieces of information being unique to each other in the first monitoring units (48a),
the second monitoring identification information is a sequence of pieces of information, each assigned to a respective second monitoring unit (48b1, 48b2, 48b3, 48b4) included in the second monitoring units (48b), the pieces of information being unique to each other in the second monitoring units (48b), and
the individual identification information is a sequence of pieces of information, each assigned to a respective first or second monitoring unit (48a1, 48a2, 48a3, 48a4, 48b1, 48b2, 48b3, 48b4) included in either the first monitoring units (48a) or the second monitoring units (48b), the pieces of information being unique to each other in all of the first monitoring units (48a) and the second monitoring units (48b).

2. The storage battery device (18) according to claim 1, wherein the battery managing unit (44) is configured to transmit, to the upper-level device (28), the upper-level communication frame that contains a plurality of pieces of the individual identification information and a plurality of pieces of the module information that are mapped to the respective pieces of individual identification information.

3. The storage battery device (18) according to claim 1, wherein the battery managing unit (44) is configured to transmit, to the upper-level device (28), the upper-level communication frame that contains a plurality of pieces of the module information that are arranged following a predetermined rule, and one piece of the individual identification information corresponding to one of the pieces of the module information.

4. A storage battery device control method comprising:
acquiring a first lower-level communication frame containing module information and first monitoring identification information from a plurality of first monitoring units (48a) that are included in a first battery system (30a) including a plurality of first battery modules (46a) and the first monitoring units (48a) detecting the module information that is information related to the first battery modules (46a), and each having first monitoring identification information;
acquiring a second lower-level communication frame containing module information and second monitoring identification information from a plurality of second monitoring units (48b) that are included in a second battery system (30b) including a plurality of second battery modules (46b) and the second monitoring units (48b) detecting the module information that is information related to the second battery modules (46b), and each having second monitoring identification information;
acquiring system identification information assigned to each of the first battery system (30a) and the second battery system (30b);
assigning individual identification information to each of the first monitoring units (48a) and the second monitoring units (48b), based on the system identification information, the first monitoring identification information, and the second monitoring identification information; and
transmitting, to an upper-level device (28), an upper-level communication frame that contains the individual identification information, and the module information detected by the first monitoring unit (48a) or the second monitoring unit (48b) corresponding to the individual identification information, and that has a larger data size than the first lower-level communication frame and the second lower-level communication frame, wherein
the first monitoring identification information is a sequence of pieces of information, each assigned to a respective first monitoring unit (48a1, 48a2, 48a3, 48a4) included in the first monitoring units (48a), the pieces of information being unique to each other in the first monitoring units (48a),
the second monitoring identification information is a sequence of pieces of information, each assigned to a respective second monitoring unit (48b1, 48b2, 48b3, 48b4) included in the second monitoring units (48b), the pieces of information being unique to each other in the second monitoring units (48b), and
the individual identification information is a sequence of pieces of information, each assigned to a respective first or second monitoring unit (48a1, 48a2, 48a3, 48a4, 48b1, 48b2, 48b3, 48b4) included in either the first monitoring units (48a) or the second monitoring units (48b), the pieces of information being unique to each other in all of the first monitoring units (48a) and the second monitoring units (48b).

5. A computer-readable medium including computer program causing a computer to execute:
acquiring, from a plurality of first monitoring units (48a) included in a first battery system (30a) that includes a plurality of first battery modules (46a) and the first monitoring units (48a) detecting module information that is information related to the first battery modules (46a), and each having first monitoring identification information, a first lower-level communication frame containing the module information and the first monitoring identification information;
acquiring, from a plurality of second monitoring units (48b) included in a second battery system (30b) that includes a plurality of second battery modules (46b) and the second monitoring units (48b) detecting module information that is information related to the second battery modules (46b), and each having second monitoring identification information, a second lower-level communication frame containing the module information and the second monitoring identification information;
acquiring system identification information assigned to the first battery system (30a) and system identification information assigned to the second battery system (30b); and
transmitting, to an upper-level device (28), an upper-level communication frame that contains individual identification information assigned to each of the first monitoring units (48a) and the second monitoring units (48b), being assigned based on the system identification information, the first monitoring identification information, and the second monitoring identification information, that also contains the module information detected by the first monitoring unit (48a) or the second monitoring unit (48b) corresponding to the individual identification information, and that has a larger data size than the first lower-level communication frame and the second lower-level communication frame, wherein
the first monitoring identification information is a sequence of pieces of information, each assigned to a respective first monitoring unit (48a1, 48a2, 48a3, 48a4) included in the first monitoring units (48a), the pieces of information being unique to each other in the first monitoring units (48a),
the second monitoring identification information is a sequence of pieces of information, each assigned to a respective second monitoring unit (48b1, 48b2, 48b3, 48b4) included in the second monitoring units (48b), the pieces of information being unique to each other in the second monitoring units (48b), and
the individual identification information is a sequence of pieces of information, each assigned to a respective first or second monitoring unit (48a1, 48a2, 48a3, 48a4, 48b1, 48b2, 48b3, 48b4) included in either the first monitoring units (48a) or the second monitoring units (48b), the pieces of information being unique to each other in all of the first monitoring units (48a) and the second monitoring units (48b).

## Patentansprüche

1. Speicherbatterievorrichtung (18), die umfasst:
ein erstes Batteriesystem (30a), das mehrere erste Batteriemodule (46a) und mehrere erste Überwachungseinheiten (48a) umfasst, die Modulinformationen detektieren, die Informationen sind, welche die ersten Batteriemodule (46a) betreffen und jeweils erste Überwachungsidentifikationsinformationen aufweisen;
ein zweites Batteriesystem (30b), das mehrere zweite Batteriemodule (46b) und mehrere zweite Überwachungseinheiten (48b) umfasst, die Modulinformationen detektieren, die Informationen sind, welche die zweiten Batteriemodule (46b) betreffen und jeweils zweite Überwachungsidentifikationsinformationen aufweisen; und
eine Batterieverwaltungseinheit (44), wobei
die Batterieverwaltungseinheit (44) ausgestaltet ist zum:
Empfangen eines ersten Kommunikationsrahmens einer niedrigeren Ebene, der die ersten Überwachungsidentifikationsinformationen und die Modulinformationen enthält, von den ersten Überwachungseinheiten (48a),
Empfangen eines zweiten Kommunikationsrahmens einer niedrigeren Ebene, der die zweiten Überwachungsidentifikationsinformationen und die Modulinformationen enthält, von den zweiten Überwachungseinheiten (46b), und
Senden, an eine Vorrichtung (28) einer höheren Ebene, eines Kommunikationsrahmens einer höheren Ebene, der individuelle Identifikationsinformationen, die jeder der ersten Überwachungseinheiten (48a) und der zweiten Überwachungseinheiten (48b) basierend auf Systemidentifikationsinformationen zugewiesen sind, die jedem von dem ersten Batteriesystem (30a) und dem zweiten Batteriesystem (30b) zugewiesen sind, die ersten Überwachungsidentifikationsinformationen und die zweiten Überwachungsidentifikationsinformationen enthält und der auch die Modulinformationen enthält, die von der ersten Überwachungseinheit (48a) oder der zweiten Überwachungseinheit (48b) detektiert werden und den individuellen Identifikationsinformationen entsprechen, und der eine größere Datengröße aufweist als der erste Kommunikationsrahmen der niedrigeren Ebene und der zweite Kommunikationsrahmen der niedrigeren Ebene;
die ersten Überwachungsidentifikationsinformationen eine Folge von Informationselementen sind, die jeweils einer entsprechenden ersten Überwachungseinheit (48a1, 48a2, 48a3, 48a4) zugewiesen sind, die in den ersten Überwachungseinheiten (48a) enthalten ist, wobei die Informationselemente in den ersten Überwachungseinheiten (48a) eindeutig zueinander sind,
die zweiten Überwachungsidentifikationsinformationen eine Folge von Informationselementen sind, die jeweils einer entsprechenden zweiten Überwachungseinheit (48b1, 48b2, 48b3, 48b4) zugewiesen sind, die in den zweiten Überwachungseinheiten (48b) enthalten ist, wobei die Informationselemente in den zweiten Überwachungseinheiten (48b) eindeutig zueinander sind, und
die individuellen Identifikationsinformationen eine Folge von Informationselementen sind, die jeweils einer entsprechenden ersten oder zweiten Überwachungseinheit (48a1, 48a2, 48a3, 48a4, 48b1, 48b2, 48b3, 48b4) zugewiesen sind, die in entweder den ersten Überwachungseinheiten (48a) oder den zweiten Überwachungseinheiten (48b) enthalten ist, wobei die Informationselemente in sämtlichen von den ersten Überwachungseinheiten (48a) und den zweiten Überwachungseinheiten (48b) eindeutig zueinander sind.

2. Speicherbatterievorrichtung (18) nach Anspruch 1, wobei die Batterieverwaltungseinheit (44) dazu ausgestaltet ist, an die Vorrichtung (28) auf der höheren Ebene den Kommunikationsrahmen auf der höheren Ebene zu übertragen, der mehrere Elemente der individuellen Identifikationsinformationen und mehrere Elemente der Modulinformationen enthält, die auf die entsprechenden Elemente individueller Identifikationsinformationen abgebildet sind.

3. Speicherbatterievorrichtung (18) nach Anspruch 1, wobei die Batterieverwaltungseinheit (44) dazu ausgestaltet ist, an die Vorrichtung (28) auf der höheren Ebene den Kommunikationsrahmen auf der höheren Ebene zu senden, der mehrere Elemente der Modulinformationen, die einer vorbestimmten Regel folgend angeordnet sind, und ein Element der individuellen Identifikationsinformationen enthält, die einem der Elemente der Modulinformationen entsprechen.

4. Speicherbatterievorrichtungssteuerungsverfahren, das umfasst:
Erfassen eines ersten Kommunikationsrahmens einer niedrigeren Ebene, der Modulinformationen und erste Überwachungsidentifikationsinformationen enthält, von mehreren von ersten Überwachungseinheiten (48a), die in einem ersten Batteriesystem (30a) enthalten sind, das mehrere erste Batteriemodule (46a) und die ersten Überwachungseinheiten (48a) umfasst, welche die Modulinformationen detektieren, die Informationen sind, welche die ersten Batteriemodule (46a) betreffen und jeweils erste Überwachungsidentifikationsinformationen aufweisen;
Erfassen eines zweiten Kommunikationsrahmens einer niedrigeren Ebene, der Modulinformationen und zweite Überwachungsidentifikationsinformationen enthält, von mehreren zweiten Batterieeinheiten (48b), die in einem zweiten Batteriesystem (30b) enthalten sind, das mehrere zweite Batteriemodule (46b) und die zweiten Überwachungseinheiten (48b) umfasst, welche die Modulinformationen detektieren, die Informationen sind, welche die zweiten Batteriemodule (46b) betreffen und jeweils zweite Überwachungsidentifikationsinformationen aufweisen;
Erfassen von Systemidentifikationsinformationen, die jedem von dem ersten Batteriesystem (30a) und dem zweiten Batteriesystem (30b) zugewiesen sind;
Zuweisen individueller Identifikationsinformationen zu jeder von den ersten Überwachungseinheiten (48a) und den zweiten Überwachungseinheiten (48b), basierend auf den Systemidentifikationsinformationen, den ersten Überwachungsidentifikationsinformationen und den zweiten Überwachungsidentifikationsinformationen; und
Senden, an eine Vorrichtung (28) einer höheren Ebene, eines Kommunikationsrahmens einer höheren Ebene, der die individuellen Identifikationsinformationen und die Modulinformationen enthält, die von der ersten Überwachungseinheit (48a) oder der zweiten Überwachungseinheit (48b) detektiert werden und den individuellen Identifikationsinformationen entsprechen, und der eine größere Datengröße aufweist als der erste Kommunikationsrahmen der niedrigeren Ebene und der zweite Kommunikationsrahmen der niedrigeren Ebene, wobei
die ersten Überwachungsidentifikationsinformationen eine Folge von Informationselementen sind, die jeweils einer entsprechenden ersten Überwachungseinheit (48a1, 48a2, 48a3, 48a4) zugewiesen sind, die in den ersten Überwachungseinheiten (48a) enthalten ist, wobei die Informationselemente in den ersten Überwachungseinheiten (48a) eindeutig zueinander sind,
die zweiten Überwachungsidentifikationsinformationen eine Folge von Informationselementen sind, die jeweils einer entsprechenden zweiten Überwachungseinheit (48b1, 48b2, 48b3, 48b4) zugewiesen sind, die in den zweiten Überwachungseinheiten (48b) enthalten ist, wobei die Informationselemente in den zweiten Überwachungseinheiten (48b) eindeutig zueinander sind, und
die einzelnen Identifikationsinformationen eine Folge von Informationselementen sind, die jeweils einer entsprechenden ersten oder zweiten Überwachungseinheit (48a1, 48a2, 48a3, 48a4, 48b1, 48b2, 48b3, 48b4) zugewiesen sind, die in entweder den ersten Überwachungseinheiten (48a) oder den zweiten Überwachungseinheiten (48b) enthalten sind, wobei die Informationselemente in sämtlichen von den ersten Überwachungseinheiten (48a) und den zweiten Überwachungseinheiten (48b) eindeutig zueinander sind.

5. Maschinenlesbarer Datenträger, der Computerprogramm umfasst, das bewirkt, dass ein Computer ausführt:
Erfassen, von mehreren von ersten Überwachungseinheiten (48a), die in einem ersten Batteriesystem (30a) enthalten sind, das mehrere erste Batteriemodule (46a) und die ersten Überwachungseinheiten (48a) umfasst, welche Modulinformationen detektieren, die Informationen sind, welche die ersten Batteriemodule (46a) betreffen und jeweils erste Überwachungsidentifikationsinformationen aufweisen, eines ersten Kommunikationsrahmens einer niedrigeren Ebene, der die Modulinformationen und die ersten Überwachungsidentifikationsinformationen enthält;
Erfassen, von mehreren zweiten Überwachungseinheiten (48b), die in einem zweiten Batteriesystem (30b) enthalten sind, das mehrere zweite Batteriemodule (46b) und die zweiten Überwachungseinheiten (48b) umfasst, welche die Modulinformationen detektieren, die Informationen sind, welche die zweiten Batteriemodule (46b) betreffen und jeweils zweite Überwachungsidentifikationsinformationen aufweisen, eines zweiten Kommunikationsrahmens einer niedrigeren Ebene, der die Modulinformationen und die zweiten Überwachungsidentifikationsinformationen enthält;
Erfassen von Systemidentifikationsinformationen, die dem ersten Batteriesystem (30a) zugewiesen sind, und Systemidentifikationsinformationen, die dem zweiten Batteriesystem (30b) zugewiesen sind;
Senden, an eine Vorrichtung (28) einer höheren Ebene, eines Kommunikationsrahmens einer höheren Ebene, der individuelle Identifikationsinformationen, die jeder von den ersten Überwachungseinheiten (48a) und den zweiten Überwachungseinheiten (48b) zugewiesen sind, die basierend auf den Systemidentifikationsinformationen zugewiesen sind, die ersten Überwachungsidentifikationsinformationen und die zweiten Überwachungsidentifikationsinformationen enthält, der auch die Modulinformationen enthält, die von der ersten Überwachungseinheit (48a) oder der zweiten Überwachungseinheit (48b) detektiert werden und den individuellen Identifikationsinformationen entsprechen, und der eine größere Datengröße aufweist als der erste Kommunikationsrahmen der niedrigeren Ebene und der zweite Kommunikationsrahmen der niedrigeren Ebene, wobei
die ersten Überwachungsinformationen eine Folge von Informationselementen sind, die jeweils einer entsprechenden ersten Überwachungseinheit (48a1, 48a2, 48a3, 48a4) zugewiesen sind, die in den ersten Überwachungseinheiten (48a) enthalten ist, wobei die Informationselemente in den ersten Überwachungseinheiten (48a) eindeutig zueinander sind,
die zweiten Überwachungsidentifikationsinformationen eine Folge von Informationselementen sind, die jeweils einer entsprechenden zweiten Überwachungseinheit (48b1, 48b2, 48b3, 48b4) zugewiesen sind, die in den zweiten Überwachungseinheiten (48b) enthalten ist, wobei die Informationselemente in den zweiten Überwachungseinheiten (48b) eindeutig zueinander sind, und
die einzelnen Identifikationsinformationen eine Folge von Informationselementen sind, die jeweils einer entsprechenden ersten oder zweiten Überwachungseinheit (48a1, 48a2, 48a3, 48a4, 48b1, 48b2, 48b3, 48b4) zugewiesen sind, die in entweder den ersten Überwachungseinheiten (48a) oder den zweiten Überwachungseinheiten (48b) enthalten ist, wobei die Informationselemente in sämtlichen von den ersten Überwachungseinheiten (48a) und den zweiten Überwachungseinheiten (48b) eindeutig zueinander sind.

## Revendications

1. Dispositif de batterie de stockage (18) comprenant :
un premier système de batterie (30a) incluant une pluralité de premiers modules de batterie (46a) et une pluralité de premières unités de surveillance (48a) détectant des informations de modules qui sont des informations relatives aux premiers modules de batterie (46a), et chacune d'elles ayant des premières informations d'identification de surveillance ;
un deuxième système de batterie (30b) incluant une pluralité de deuxièmes modules de batterie (46b) et une pluralité de deuxièmes unités de surveillance (48b) détectant des informations de modules qui sont des informations relatives aux deuxièmes modules de batterie (46b), et chacune d'elles ayant des deuxièmes informations d'identification de surveillance ; et
une unité de gestion de batterie (44), dans lequel
l'unité de gestion de batterie (44) est configurée pour :
recevoir une première trame de communication de niveau inférieur contenant les premières informations d'identification de surveillance et les informations de modules depuis les premières unités de surveillance (48a),
recevoir une deuxième trame de communication de niveau inférieur contenant les deuxièmes informations d'identification de surveillance et les informations de modules depuis les deuxièmes unités de surveillance (48b), et
transmettre, à un dispositif de niveau supérieur (28), une trame de communication de niveau supérieur qui contient des informations d'identification individuelle attribuées à chacune des premières unités de surveillance (48a) et des deuxièmes unités de surveillance (48b) sur la base d'informations d'identification de système attribuées à chacun du premier système de batterie (30a) et du deuxième système de batterie (30b), des premières informations d'identification de surveillance et des deuxièmes informations d'identification de surveillance, et qui contient également les informations de modules détectées par la première unité de surveillance (48a) ou la deuxième unité de surveillance (48b) correspondant aux informations d'identification individuelle, et qui présente une taille de données plus grande que celle de la première trame de communication de niveau inférieur et de la deuxième trame de communication de niveau inférieur ;
les premières informations d'identification de surveillance sont une séquence d'informations qui sont chacune attribuées à une première unité de surveillance (48a1, 48a2, 48a3, 48a4) respective incluse dans les premières unités de surveillance (48a), les informations étant uniques les unes par rapport aux autres dans les premières unités de surveillance (48a),
les deuxièmes informations d'identification de surveillance sont une séquence d'informations qui sont chacune attribuées à une deuxième unité de surveillance (48b1, 48b2, 48b3, 48b4) respective incluse dans les deuxièmes unités de surveillance (48b), les informations étant uniques les unes par rapport aux autres dans les deuxièmes unités de surveillance (48b), et
les informations d'identification individuelle sont une séquence d'informations qui sont chacune attribuées à une première ou deuxième unité de surveillance (48a1, 48a2, 48a3, 48a4, 48b1, 48b2, 48b3, 48b4) respective incluse soit dans les premières unités de surveillance (48a) soit dans les deuxièmes unités de surveillance (48b), les informations étant uniques les unes par rapport aux autres dans l'intégralité des premières unités de surveillance (48a) et des deuxièmes unités de surveillance (48b).

2. Dispositif de batterie de stockage (18) selon la revendication 1, dans lequel l'unité de gestion de batterie (44) est configurée pour transmettre, au dispositif de niveau supérieur (28), la trame de communication de niveau supérieur qui contient une pluralité des informations d'identification individuelle et une pluralité des informations de modules qui sont mises en correspondance avec les informations d'identification individuelle respectives.

3. Dispositif de batterie de stockage (18) selon la revendication 1, dans lequel l'unité de gestion de batterie (44) est configurée pour transmettre, au dispositif de niveau supérieur (28), la trame de communication de niveau supérieur qui contient une pluralité des informations de modules qui sont agencées dans le respect d'une règle prédéterminée, et l'une des informations d'identification individuelle correspondant à l'une des informations de modules.

4. Procédé de commande de dispositif de batterie de stockage comprenant :
l'acquisition d'une première trame de communication de niveau inférieur contenant des informations de modules et des premières informations d'identification de surveillance à partir d'une pluralité de premières unités de surveillance (48a) qui sont incluses dans un premier système de batterie (30a) incluant une pluralité de premiers modules de batterie (46a) et les premières unités de surveillance (48a) détectant les informations de modules qui sont des informations relatives aux premiers modules de batterie (46a), chacune d'elles ayant des premières informations d'identification de surveillance ;
l'acquisition d'une deuxième trame de communication de niveau inférieur contenant des informations de modules et des deuxièmes informations d'identification de surveillance à partir d'une pluralité de deuxièmes unités de surveillance (48b) qui sont incluses dans un deuxième système de batterie (30b) incluant une pluralité de deuxièmes modules de batterie (46b) et les deuxièmes unités de surveillance (48b) détectant les informations de modules qui sont des informations relatives aux deuxièmes modules de batterie (46b), chacune d'elles ayant des deuxièmes informations d'identification de surveillance ;
l'acquisition d'informations d'identification de système attribuées à chacun du premier système de batterie (30a) et du deuxième système de batterie (30b) ;
l'attribution d'informations d'identification individuelle à chacune des premières unités de surveillance (48a) et des deuxièmes unités de surveillance (48b), sur la base des informations d'identification de système, des premières informations d'identification de surveillance et des deuxièmes informations d'identification de surveillance ; et
la transmission, à un dispositif de niveau supérieur (28), d'une trame de communication de niveau supérieur qui contient les informations d'identification individuelle et les informations de modules détectées par la première unité de surveillance (48a) ou la deuxième unité de surveillance (48b) correspondant aux informations d'identification individuelle, et qui présente une taille de données plus grande que celle de la première trame de communication de niveau inférieur et de la deuxième trame de communication de niveau inférieur, dans lequel
les premières informations d'identification de surveillance sont une séquence d'informations qui sont chacune attribuées à une première unité de surveillance (48a1, 48a2, 48a3, 48a4) respective incluse dans les premières unités de surveillance (48a), les informations étant uniques les unes par rapport aux autres dans les premières unités de surveillance (48a),
les deuxièmes informations d'identification de surveillance sont une séquence d'informations qui sont chacune attribuées à une deuxième unité de surveillance (48b1, 48b2, 48b3, 48b4) respective incluse dans les deuxièmes unités de surveillance (48b), les informations étant uniques les unes par rapport aux autres dans les deuxièmes unités de surveillance (48b), et
les informations d'identification individuelle sont une séquence d'informations qui sont chacune attribuées à une première ou deuxième unité de surveillance (48a1, 48a2, 48a3, 48a4, 48b1, 48b2, 48b3, 48b4) respective incluse soit dans les premières unités de surveillance (48a) soit dans les deuxièmes unités de surveillance (48b), les informations étant uniques les unes par rapport aux autres dans l'intégralité des premières unités de surveillance (48a) et des deuxièmes unités de surveillance (48b).

5. Support lisible par ordinateur comprenant un programme informatique amenant un ordinateur à exécuter :
l'acquisition, à partir d'une pluralité de premières unités de surveillance (48a) qui sont incluses dans un premier système de batterie (30a) incluant une pluralité de premiers modules de batterie (46a) et les premières unités de surveillance (48a) détectant des informations de modules qui sont des informations relatives aux premiers modules de batterie (46a), chacune d'elles ayant des premières informations d'identification de surveillance, d'une première trame de communication de niveau inférieur contenant les informations de modules et les premières informations d'identification de surveillance ;
l'acquisition, à partir d'une pluralité de deuxièmes unités de surveillance (48b) qui sont incluses dans un deuxième système de batterie (30b) incluant une pluralité de deuxièmes modules de batterie (46b) et les deuxièmes unités de surveillance (48b) détectant des informations de modules qui sont des informations relatives aux deuxièmes modules de batterie (46b), chacune d'elles ayant des deuxièmes informations d'identification de surveillance, d'une deuxième trame de communication de niveau inférieur contenant les informations de modules et les deuxièmes informations d'identification de surveillance ;
l'acquisition d'informations d'identification de système attribuées au premier système de batterie (30a) et d'informations d'identification de système attribuées au deuxième système de batterie (30b) ; et
la transmission, à un dispositif de niveau supérieur (28), d'une trame de communication de niveau supérieur qui contient des informations d'identification individuelle attribuées à chacune des premières unités de surveillance (48a) et des deuxièmes unités de surveillance (48b), étant attribuées sur la base des informations d'identification de système, des premières informations d'identification de surveillance et des deuxièmes informations d'identification de surveillance, contenant également les informations de modules détectées par la première unité de surveillance (48a) ou la deuxième unité de surveillance (48b) correspondant aux informations d'identification individuelle, et qui présente une taille de données plus grande que celle de la première trame de communication de niveau inférieur et de la deuxième trame de communication de niveau inférieur, dans lequel
les premières informations d'identification de surveillance sont une séquence d'informations qui sont chacune attribuées à une première unité de surveillance (48a1, 48a2, 48a3, 48a4) respective incluse dans les premières unités de surveillance (48a), les informations étant uniques les unes par rapport aux autres dans les premières unités de surveillance (48a),
les deuxièmes informations d'identification de surveillance sont une séquence d'informations qui sont chacune attribuées à une deuxième unité de surveillance (48b1, 48b2, 48b3, 48b4) respective incluse dans les deuxièmes unités de surveillance (48b), les informations étant uniques les unes par rapport aux autres dans les deuxièmes unités de surveillance (48b), et
les informations d'identification individuelle sont une séquence d'informations qui sont chacune attribuées à une première ou deuxième unité de surveillance (48a1, 48a2, 48a3, 48a4, 48b1, 48b2, 48b3, 48b4) respective incluse soit dans les premières unités de surveillance (48a) soit dans les deuxièmes unités de surveillance (48b), les informations étant uniques les unes par rapport aux autres dans l'intégralité des premières unités de surveillance (48a) et des deuxièmes unités de surveillance (48b).
